# EUROPEAN PATENT APPLICATION

(11) **EP 3 091 576 A1**
(43) Date of publication of application: **09.11.2016**
(21) Application number: 13900494.9
(22) Date of filing: 25.12.2013
(51) Int. Cl.: H01L 27/146

(54) **IMAGE PICKUP APPARATUS, IMAGE PICKUP SYSTEM, AND IMAGE PICKUP APPARATUS MANUFACTURING METHOD**

(71) Applicant: Canon Kabushiki Kaisha, Tokyo 146-8501 (JP)
(72) Inventor: SHINOHARA Mahito, Tokyo 146-8501 (JP); KOBAYASHI Masahiro, Tokyo 146-8501 (JP); ITAHASHI Masatsugu, Tokyo 146-8501 (JP)
(74) Representative: Houle, Timothy James
(86) International application number: PCT/JP2013/084566
(87) International publication number: WO 2015/097771

(57) **Abstract**

Variation in the characteristics of a junction type field effect transistor can be reduced.

An embodiment of the present invention is an imaging apparatus that includes a plurality of pixels, each including a junction type field effect transistor provided in a semiconductor substrate. The junction type field effect transistor includes a gate region and a channel region. The gate region and the channel region intersect each other in plan view.

## Description

### Technical Field

The present invention relates to an imaging apparatus, an imaging system, and a method for manufacturing the imaging apparatus.

### Background Art

An imaging apparatus which utilizes junction type field effect transistors has been proposed. Patent Literature (PTL) 1 describes an imaging apparatus including a plurality of pixels. Each pixel includes a junction type field effect transistor. In the junction type field effect transistor described in PTL 1, a channel region is interposed between a surface gate region and a buried gate region. The channel region is connected to a drain region at the end portion of the buried gate region.

PTL 2 describes a method for forming a junction type field effect transistor. In the method described in PTL 1, a surface gate region, a channel region, and source and drain regions of the junction type field effect transistor are formed by ion implantation using different resist patterns as masks.

### Citation List

### Patent Literature

PTL 1: Japanese Patent Laid-Open No. 2007-165736
PTL 2: Japanese Patent Laid-Open No. 2006-196789

### Summary of Invention

### Technical Problem

In the junction type field effect transistor described in PTL 1, a drain-side end of the channel region is determined by the end position of the gate region, whereas a source-side end of the channel region is determined by the position of the source region. Therefore, if there is an alignment error between a mask used to form the source region and a mask used to form the buried gate region, the channel length may be changed. This causes variation in the characteristics of the junction type field effect transistor.

In the method described in PTL 2, if there is an alignment error between a mask used to form the surface gate region and a mask used to form the channel region, the channel width may be changed. This causes variation in the characteristics of the junction type field effect transistor.

In view of the problems described above, the present invention aims to provide an imaging apparatus in which less variation in the characteristics of a junction type field effect transistor is achieved.

### Solution to Problem

An embodiment according to an aspect of the present invention is a method for manufacturing an imaging apparatus that includes a plurality of pixels, each including a junction type field effect transistor provided in a semiconductor substrate. The method includes a step of forming a gate region of the junction type field effect transistor by introducing an impurity into the semiconductor substrate using a first mask which defines a first opening, and a step of forming a channel region of the junction type field effect transistor by introducing an impurity into the semiconductor substrate using a second mask which defines a second opening. The second opening includes a source-side portion corresponding to a source-side portion of the channel region, and a drain-side portion corresponding to a drain-side portion of the channel region. An orthogonal projection of the first opening onto a plane parallel to a surface of the semiconductor substrate intersects an orthogonal projection of the second opening onto the plane. Each of an orthogonal projection of the source-side portion of the second opening onto the plane and an orthogonal projection of the drain-side portion of the second opening onto the plane overlaps an orthogonal projection of the first mask onto the plane.

An embodiment according to another aspect of the present invention is a method for forming an imaging apparatus that includes a plurality of pixels, each including a junction type field effect transistor provided in a semiconductor substrate. The method includes a step of forming a gate region of the junction type field effect transistor in the semiconductor substrate, and a step of forming a channel region of the junction type field effect transistor in the semiconductor substrate. An orthogonal projection of a first region onto a plane parallel to a surface of the semiconductor substrate intersects an orthogonal projection of a second region onto the plane. The first region is a region into which an impurity is introduced in the step of forming the gate region, and the second region is a region into which an impurity is introduced in the step of forming the channel region. In the plane, each of a source-side portion and a drain-side portion of the orthogonal projection of the second region protrudes out of the orthogonal projection of the first region.

An embodiment according to still another aspect of the present invention is an imaging apparatus that includes a plurality of pixels, each including a junction type field effect transistor provided in a semiconductor substrate. The junction type field effect transistor includes a gate region and a channel region. An orthogonal projection of the gate region onto a plane parallel to a surface of the semiconductor substrate intersects an orthogonal projection of the channel region onto the plane. In the plane, each of a source-side portion and a drain-side portion of the orthogonal projection of the channel region protrudes out of the orthogonal projection of the gate region.

An embodiment according to still another aspect of the present invention is an imaging apparatus that includes a plurality of pixels, each including a junction type field effect transistor provided in a semiconductor substrate. The junction type field effect transistor includes a surface gate region, a buried gate region, and a channel region which are disposed at different depths. The channel region is disposed at a depth between the surface gate region and the buried gate region. Each of an orthogonal projection of the surface gate region onto a plane parallel to a surface of the semiconductor substrate and an orthogonal projection of the buried gate region onto the plane intersects an orthogonal projection of the channel region onto the plane. Advantageous Effects of Invention

The present invention can reduce variation in the characteristics of a junction type field effect transistor. Brief Description of Drawings

[Fig. 1] Fig. 1 schematically illustrates a planar structure of an imaging apparatus.
[Fig. 2] Fig. 2 schematically illustrates a cross-sectional structure of the imaging apparatus.
[Fig. 3] Fig. 3 schematically illustrates a cross-sectional structure of the imaging apparatus.
[Fig. 4] Fig. 4 is for explaining a method for manufacturing the imaging apparatus.
[Fig. 5] Fig. 5 schematically illustrates masks used to manufacture the image apparatus.
[Fig. 6] Fig. 6 schematically illustrates a planar structure and cross-sectional structures of imaging apparatuses.
[Fig. 7] Fig. 7 schematically illustrates a planar structure of an imaging apparatus.
[Fig. 8] Fig. 8 schematically illustrates a cross-sectional structure of the imaging apparatus.
[Fig. 9] Fig. 9 is for explaining a method for manufacturing an imaging apparatus.
[Fig. 10] Fig. 10 is a block diagram of an imaging system.

### Description of Embodiments

An embodiment of the present invention is an imaging apparatus including a plurality of pixels. Each pixel includes a junction type field effect transistor (hereinafter referred to as JFET). The JFET includes a gate region, a channel region, a drain region, and a source region formed in a semiconductor substrate. In the JFET, a conductivity type of the gate region is different from that of the channel region, the drain region, and the source region. In the present embodiment, a lateral JFET is used, in which the direction of channel current is parallel to the surface of the semiconductor substrate.

Embodiments of the present invention are characterized by the structure of the gate region and the channel region or the method for manufacturing them. Specifically, the gate region and the channel region are formed to intersect each other in plan view. The arrangements or shapes of components in plan view, described in the present specification, refer to the arrangements or shapes of orthogonal projections of the components onto a plane parallel to the surface of the semiconductor substrate. That is, an orthogonal projection of the gate region onto a plane parallel to the surface of the semiconductor substrate and an orthogonal projection of the channel region onto the plane parallel to the surface of the semiconductor substrate intersect each other in the plane. The surface of the semiconductor substrate is an interface between a semiconductor region and an insulator.

Intersecting of two regions means that each region is disposed to cross over the other region. In other words, intersecting of two regions means that at least two parts of one region protrude out of the other region and that at least two parts of the other region protrude out of the one region. If one region contains the other region, the two regions do not intersect each other.

In the manufacturing method of embodiments according to the present invention, a plurality of masks are used to form the gate region and the channel region. The masks have respective openings that intersect each other in plan view.

With this configuration, even though there could be alignment errors between the mask used to form the gate region and the mask used to form the channel region, the shape of the intersectional part of the gate region and the channel region is almost unchanged. That is, variation in the channel length and the channel width of the JFET can be reduced. Thus, variation in the characteristics of the JFET can be reduced.

Hereinafter, embodiments of the present invention will be described with reference to the drawings. In the embodiments described below, the gate region is of P-type, whereas the channel region, the drain region, and the source region are of N-type. The present invention is not restricted only to the embodiments described below. For example, the conductivity type of each semiconductor region may be reversed. Also, examples in which part of the configuration of one of the following embodiments is added to another embodiment or replaced with part of the configuration of another embodiment are also embodiments of the present invention.

### First Embodiment

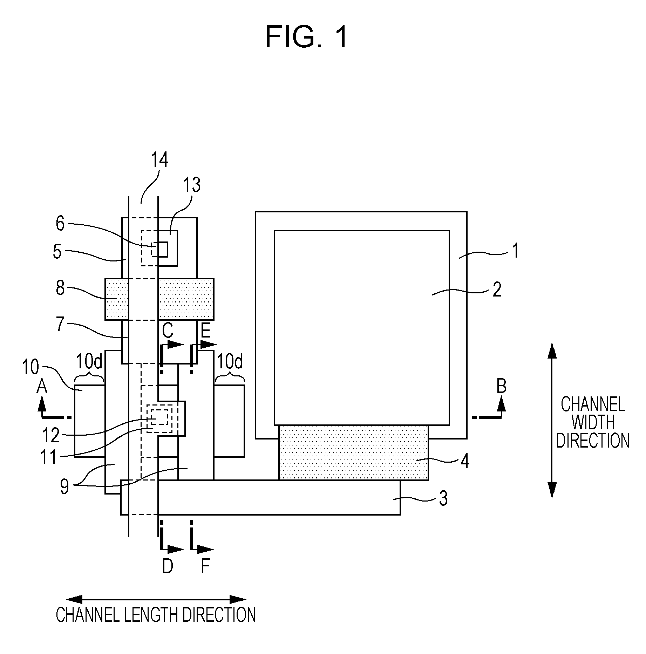

Fig. 1 schematically illustrates a planar structure of an imaging apparatus of the present embodiment. One pixel is illustrated in Fig. 1. The pixel includes a photoelectric conversion portion such as a photodiode, a transfer transistor, a reset transistor, and a JFET. The imaging apparatus of the present embodiment includes a plurality of pixels, and one of which is the one illustrated in Fig. 1.

The photoelectric conversion portion of the present embodiment is a photodiode. The photodiode includes an N-type semiconductor region 1 formed in the surface of the semiconductor substrate and a P-type semiconductor region 2 formed under the N-type semiconductor region 1. The N-type semiconductor region 1 and the P-type semiconductor region 2 form a P-N junction. A hole generated by incident light is accumulated in the P-type semiconductor region 2 as a signal charge. The signal charge accumulated in the P-type semiconductor region 2 is transferred to a floating diffusion region 3 (hereinafter referred to as FD region 3). The FD region 3 is a P-type semiconductor region. A transfer gate electrode 4 transfers the signal charge from the P-type semiconductor region 2 to the FD region 3.

The JFET includes a P-type gate region 9, an N-type channel region 10, and an N-type source region 11. A channel controlled by a voltage of the gate region 9 is formed in at least part of the N-type channel region 10. The JFET of the present embodiment includes a plurality of gate regions 9. The channel region 10 intersects each of the gate regions 9 in plan view. The channel region 10 is disposed to cross the gate region 9 from the source side to the drain side. A part (region 10d in Fig. 1) of the channel region 10 forms a drain region of the JFET. The channel of the JFET is formed in an intersectional part of the gate region 9 and the channel region 10. An impurity density in the source region 11 is higher than that in the channel region 10. The source region 11 is electrically connected to an output line 14 via a contact plug 12. The FD region 3 is electrically connected to the gate region 9. With this configuration, the JFET outputs a signal corresponding to the voltage of the FD region 3 to the output line 14.

A reset MOS transistor includes a P-type drain region 5, a P-type source region 7, and a gate electrode 8. The drain region 5 is electrically connected to a reset drain wiring 13 via a contact plug 6. The source region 7 of the reset MOS transistor is electrically connected to the gate region 9 of the JFET. With this configuration, the reset MOS transistor resets the voltage of a gate of the JFET. Using a MOS transistor as the reset transistor is simple. Other types of transistors, including a JFET, may be used as the reset transistor.

The JFET of the present embodiment includes a plurality of gate regions 9 spreading out in plan view. The gate regions 9 are arranged, with the source region 11 interposed therebetween in plan view. In other words, an orthogonal projection of the source region 11 onto a plane parallel to the surface of the semiconductor substrate is located between orthogonal projections of the gate regions 9 onto the plane. The JFET of the present embodiment further includes a plurality of drain regions. More specifically, the channel region 10 includes a plurality of drain-side portions 10d. Each of the drain regions is disposed on the opposite side of the source region 11 with respect to the corresponding one of the gate regions 9. The channel is formed for each of the gate regions 9. The gate regions 9 are preferably arranged in parallel to each other in plan view. The gate regions 9 are electrically connected to each other by a semiconductor region having the same conductivity type. In the present embodiment, the FD region 3 and the source region 7 of the reset MOS transistor electrically connect the gate regions 9 to each other.

With this configuration, the effective channel width of the JFET can be widened. That is, since the driving force of the JFET can be improved, the imaging apparatus can be driven at a high speed. The JFET may include only one gate region. Specifically, one of the two gate regions 9 illustrated in Fig. 1 and the corresponding drain region may be removed.

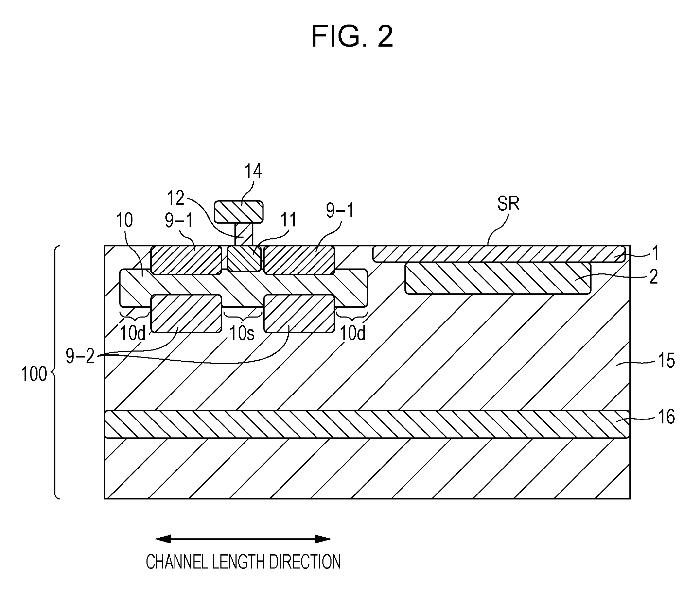

Fig. 2 is a diagram schematically illustrating a cross-sectional structure of the imaging apparatus of the present embodiment. Fig. 2 schematically illustrates the cross-sectional structure taken along line A-B in Fig. 1. The same parts as those in Fig. 1 are designated by the same reference numerals.

Fig. 2 illustrates a semiconductor substrate 100. An insulator film (not shown) is provided on the semiconductor substrate 100. A surface SR of the semiconductor substrate 100 is an interface between the semiconductor substrate 100 and the insulator film (not shown). A channel length direction is a direction parallel to both the plane of Fig. 2 and the surface SR.

The photodiode and the JFET are formed in an N-type semiconductor region 15. A drain current of the JFET is provided via the N-type semiconductor region 15. Although not shown, a drain current providing portion configured to provide the drain current for the N-type semiconductor region 15 is formed outside a pixel area or in part of the pixel area. For example, the drain current providing portion is a contact plug that connects the semiconductor substrate to a wiring.

An N-type semiconductor region 16 having a higher impurity density than the N-type semiconductor region 15 is disposed under the N-type semiconductor region 15. The resistance of the semiconductor substrate can be lowered by the N-type semiconductor region 16. With this configuration, it is possible to reduce a voltage drop in the semiconductor substrate caused by the drain current provided for the JFET. Thus, it is possible to reduce noise, such as shading caused by the voltage of the semiconductor substrate that varies depending on the location. As a result, image quality can be improved. The drain current of the JFET can also be increased. As a result, the imaging apparatus can be driven at a high speed.

The part 10d of the channel region 10 may be omitted and a part of the N-type semiconductor region 15 may form a drain region. The drain region is an N-type semiconductor region which is disposed, in plan view, adjacent to a region where the channel is to be formed.

The gate region 9 of the JFET of the present embodiment includes a surface gate region 9-1 and a buried gate region 9-2. Both the surface gate region 9-1 and the buried gate region 9-2 are of P-type. The surface gate region 9-1 and the buried gate region 9-2 are disposed at different depths. The channel region 10 is disposed at a depth between the surface gate region 9-1 and the buried gate region 9-2. With this configuration, a lateral JFET is formed. In the lateral JFET, as illustrated in Fig. 2, the channel length direction is parallel to the surface of the semiconductor substrate.

The surface gate region 9-1 and the buried gate region 9-2 are electrically connected to each other. A connection portion between the surface gate region 9-1 and the buried gate region 9-2 is disposed not to overlap the channel region 10 in plan view. With this configuration, the channel of the JFET can be controlled by both of the gate regions.

The surface gate region 9-1 and the buried gate region 9-2 overlap each other in plan view. In other words, an orthogonal projection of the surface gate region 9-1 onto a plane parallel to the surface of the semiconductor substrate is identical to an orthogonal projection of the buried gate region 9-2 onto the plane. With this configuration, the surface gate region 9-1 and the buried gate region 9-2 can be formed with the same mask. This is advantageous for reducing variation in the characteristics of the JFET.

The orthogonal projection of the surface gate region 9-1 does not necessary need to be identical to the orthogonal projection of the buried gate region 9-2. For example, the surface gate region 9-1 and the buried gate region 9-2 may be arranged such that the surface gate region 9-1 intersects the channel region 10 while the buried gate region contains the channel region 10 in plan view. In this case, the surface gate region and the buried gate region are formed using different masks.

One of the surface gate region 9-1 and the buried gate region 9-2 may be omitted. In the present embodiment, each of the gate regions 9 spreading out in plan view includes the surface gate region 9-1 and the buried gate region 9-2. Alternatively, at least one of the gate regions 9 may include the surface gate region 9-1 and the buried gate region 9-2.

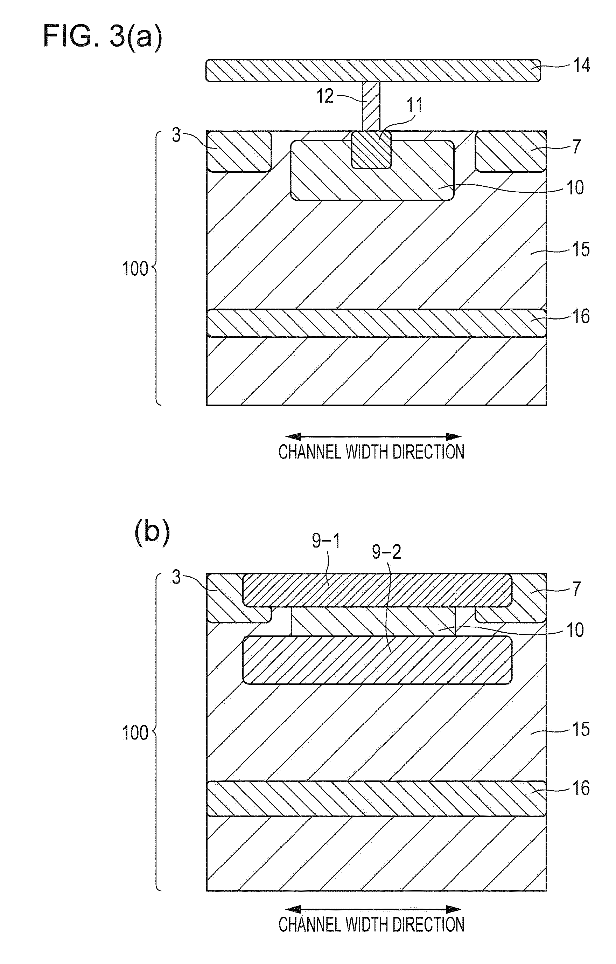

Fig. 3(a) is a diagram schematically illustrating a cross-sectional structure of the imaging apparatus of the present embodiment. Fig. 3(a) schematically illustrates the cross-sectional structure taken along line C-D in Fig. 1. The same parts as those in Figs. 1 and 2 are designated by the same reference numerals. A channel width direction is a direction parallel to both the plane of Fig. 3(a) and the surface SR.

As illustrated in Fig. 3(a), in a space below the source region 11, no P-type semiconductor regions are provided between the channel region 10 and the N-type semiconductor region 15. However, the channel region 10 and the N-type semiconductor region 15 are electrically isolated from each other. Specifically, a depletion layer formed between the two buried gate regions 9-2 and the N-type semiconductor region 15 shown in Fig. 2 forms a potential barrier between the channel region 10 and the N-type semiconductor region 15. This prevents ohmic conduction between the channel region 10 and the N-type semiconductor region 15. In practice, potential profiles are preferably designed such that electrical resistance between the channel region 10 and the N-type semiconductor region 15 of the JFET, in a direction perpendicular to the surface SR, is substantially higher than electrical resistance between the source and the drain of the JFET, in the channel length direction.

Fig. 3(b) is a diagram schematically illustrating a cross-sectional structure of the imaging apparatus of the present embodiment. Fig. 3(b) schematically illustrates the cross-sectional structure taken along line E-F in Fig. 1. The same parts as those in Figs. 1 to 3(a) are designated by the same reference numerals. A channel width direction is a direction parallel to both the plane of Fig. 3(b) and the surface SR.

As mentioned above, the surface gate region 9-1 and the buried gate region 9-2 are electrically connected to each other. In the present embodiment, the semiconductor region having the same conductivity type electrically connects the surface gate region 9-1 and the buried gate region 9-2. For example, in Fig. 3(b), the FD region 3 and the source region 7 of the reset MOS transistor may extend deep into the substrate to the extent that they electrically connect the surface gate region 9-1 and the buried gate region 9-2. Although the surface gate region 9-1 and the buried gate region 9-2 are spaced from each other in Fig. 3(b), the surface gate region 9-1 and the buried gate region 9-2 may be continuously formed by impurity diffusion in a direction perpendicular to the surface SR.

In the present embodiment, the gate region 9 and the channel region 10 intersect each other in the planar structure illustrated in Fig. 1. In other words, the orthogonal projection of the gate region 9 onto the plane parallel to the surface of the semiconductor substrate and the orthogonal projection of the channel region 10 onto the plane parallel to the surface of the semiconductor substrate intersect each other.

Intersecting of the gate region 9 and the channel region 10 means that each region is disposed to cross over the other region. In other words, at least two parts of the gate region 9 protrude out of the channel region 10 and at least two parts of the channel region 10 protrude out of the gate region 9.

A part of the channel region 10 disposed between the two gate regions 9 in plan view of Fig. 1 is a source-side portion 10s of the channel region 10. A part of the channel region 10 disposed on the opposite side of the source-side region 10s with respect to the gate region 9 is the drain-side portion 10d of the channel region 10. Fig. 2 also illustrates the source-side portion 10s and the drain-side portion 10d. Each of the source-side portion 10s and the drain-side portion 10d of the channel region 10 does not overlap the gate region 9. In other words, the source-side portion 10s and the drain-side portion 10d of the orthogonal projection of the channel region 10 protrude out of the orthogonal projection of the gate region 9. Therefore, as illustrated in Fig. 2, the channel length of the JFET is defined by the end of the gate region 9. As illustrated in Fig. 3(b), the channel width of the JFET is defined by the end of the channel region 10.

With this configuration, even though there could be alignment errors between a mask used to form the gate region 9 and a mask used to form the channel region 10, the shape of the channel of the JFET is almost unchanged. That is, variation in the channel length and the channel width of the JFET can be reduced. Thus, variation in the characteristics of the JFET can be reduced.

Referring to Fig. 2, electrons from the source region 11 of the JFET run, in the channel length direction, through the channel formed between the surface gate region 9-1 and the buried gate region 9-2, and eventually flow into the N-type semiconductor region 15. The magnitude of this channel current is basically determined by the voltage of the source region 11, the voltage of the gate region 9, the voltage of the N-type semiconductor region 15 which is the drain region, the channel length, and the channel width.

In the present embodiment, the channel length and the channel width of the JFET are determined by two rectangles which are the intersectional portions of the gate region 9 and the channel region 10 in Fig. 1. The channel length is the length of a side of the rectangle of the intersectional portion in the channel length direction. Since the channel current runs in both directions, the channel width is twice the length of a side of the rectangle of the intersectional portion in the channel width direction.

In the present embodiment, the gate regions 9 are two rectangular regions parallel to each other, and the channel region 10 is also rectangular. The gate region 9 and the channel region 10 are arranged to overlap as being oversized with respect to each other. That is, the gate region 9 is oversized with respect to the channel region 10 in the channel width direction of Fig. 1, and the channel region 10 is oversized with respect to the gate region 9 in the channel length direction of Fig. 1. Accordingly, even though there could be alignment errors between a mask used to form the gate region 9 and a mask used to form the channel region 10, the shape of the rectangle of the intersectional portion is almost unchanged. Therefore, in the process of forming the JFET, variation in the electrical characteristics of the JFET caused by alignment errors can be reduced.

The reduction of variation in the electrical characteristics of the JFET is achieved regardless of the shapes of the gate region 9 and the channel region 10. This reduction of variation is achieved by the intersection of the gate region 9 and the channel region 10 in plan view. Preferably, as illustrated in Fig. 1, the periphery of the gate region 9 in plan view includes two parallel lines along the channel width direction. With this configuration, the variation in the electrical characteristics can be further reduced. Preferably, as illustrated in Fig. 1, the periphery of the channel region 10 in plan view includes two parallel lines along the channel length direction. With this configuration, the variation in the electrical characteristics can be further reduced. If the gate region 9 and the channel region 10 are rectangular in shape, it is easier to form masks used to form the gate region 9 and the channel region 10. The peripheries of the gate region 9 and the channel region 10 in plan view may include curves. With this configuration, it is possible to reduce variation in characteristics caused by alignment errors resulting from rotation of masks.

The channel length of the JFET is determined by the distance between the drain-side end and the source-side end. Therefore, when the drain-side portion and the source-side portion of the channel region 10 are disposed separately on both sides of the gate region 9 in plan view, variation in electrical characteristics can be reduced. That is, since each of the source-side portion and the drain-side portion of the orthogonal projection of the channel region 10 protrudes out of the orthogonal projection of the gate region, the variation in electrical characteristics described above can be reduced.

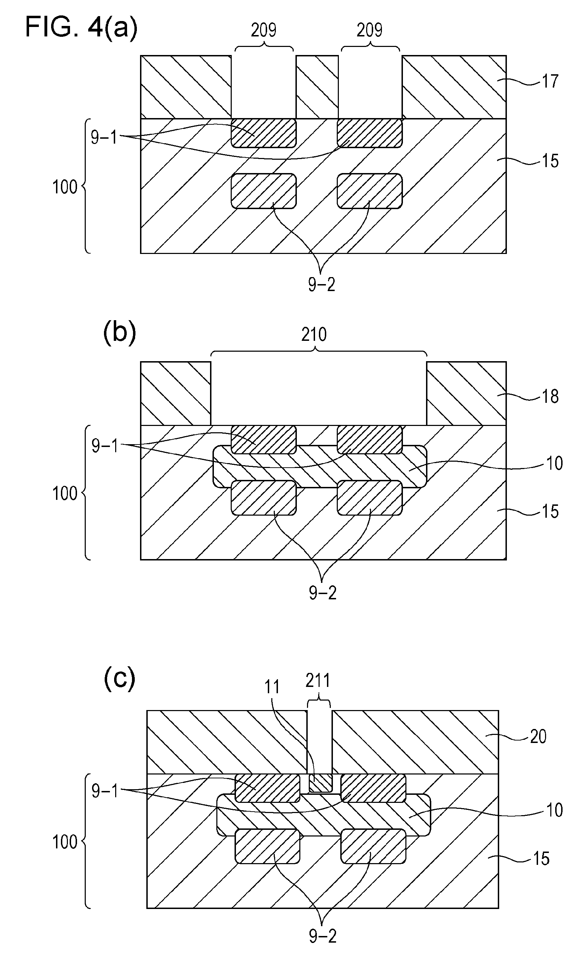

Hereinafter, an example of a method for manufacturing the imaging apparatus of the present embodiment will be explained. Fig. 4 is for explaining the method for manufacturing the imaging apparatus. Each of Figs. 4(a) to 4(c) schematically illustrates a cross-sectional structure taken along line A-B in Fig. 1. The same parts as those in Figs. 1 to 3 are designated by the same reference numerals.

A step illustrated in Fig. 4(a) involves forming the gate region 9 of the JFET. In this step, a first mask 17 which defines a first opening 209 is used. The first mask 17 is obtained, for example, by patterning a photoresist using a photolithography method.

Impurities to be acceptors, such as boron, are introduced into the semiconductor substrate 100 through the first opening 209, whereby the gate region 9 is formed in a region corresponding to the first opening 209 of the semiconductor substrate 100. For example, the gate region 9 can be formed by ion implantation using the first mask 17. By performing ion implantation multiple times at different ion implantation energies, the surface gate region 9-1 and the buried gate region 9-2 are formed at different depths. When a higher ion implantation energy is used, a semiconductor region can be formed deeper in the semiconductor substrate 100. By selecting a predetermined ion implantation energy, the surface gate region 9-1 and the buried gate region 9-2 are formed to be electrically connected to each other by impurity diffusion in a direction perpendicular to the surface SR of the semiconductor substrate 100.

Besides the ion implantation, a semiconductor process, such as thermal diffusion, can be used to introduce impurities into the semiconductor substrate 100. After forming the gate region 9, the first mask 17 is removed.

A step illustrated in Fig. 4(b) involves forming the channel region 10 of the JFET. In this step, a second mask 18 which defines a second opening 210 is used. The second mask 18 is obtained, for example, by patterning a photoresist using a photolithography method.

Impurities to be donors, such as phosphorus or arsenic, are introduced into the semiconductor substrate 100 through the second opening 210, whereby the channel region 10 is formed in a region corresponding to the second opening 210 of the semiconductor substrate 100. For example, the channel region 10 can be formed by ion implantation using the second mask 18. In this case, by adjusting an ion implantation energy, the channel region 10 can be formed at a depth between the surface gate region 9-1 and the buried gate region 9-2. After forming the channel region 10, the second mask 18 is removed.

Although not shown in Fig. 4, a P-type semiconductor region that electrically connects the plurality of gate regions 9 to each other may be formed using a third mask 19 that defines third openings 203 and 207. The third mask 19 is obtained, for example, by patterning a photoresist using a photolithography method.

In the present embodiment, the FD region 3 and the source region 7 of the reset MOS transistor are formed using the third mask 19. These regions electrically connect the plurality of gate regions 9 to each other. After forming the P-type semiconductor region that electrically connects the gate regions 9 to each other, the third mask 19 is removed.

A step illustrated in Fig. 4(c) involves forming the source region 11 which is electrically connected to the source-side portion of the channel region 10. In this step, a mask 20 which defines an opening 211 is used. The mask 20 is a hard mask. That is, the mask 20 includes an insulator film made of an inorganic material, such as a silicon oxide film, a silicon nitride film, or a silicon oxy-nitride film.

Impurities to be donors, such as phosphorus or arsenic, are introduced into the semiconductor substrate 100 through the opening 211, whereby the source region 11 is formed in a region corresponding to the opening 211 of the semiconductor substrate 100.

When a hard mask is used as the mask 20 as described above, the mask can be used as an interlayer insulation film. Specifically, after forming the source region 11, the mask 20 is not removed, and the contact plug 12 electrically connected to the source region 11 is placed in the opening 211. Then, the output line 14 connected to the contact plug 12 is formed on the mask 20.

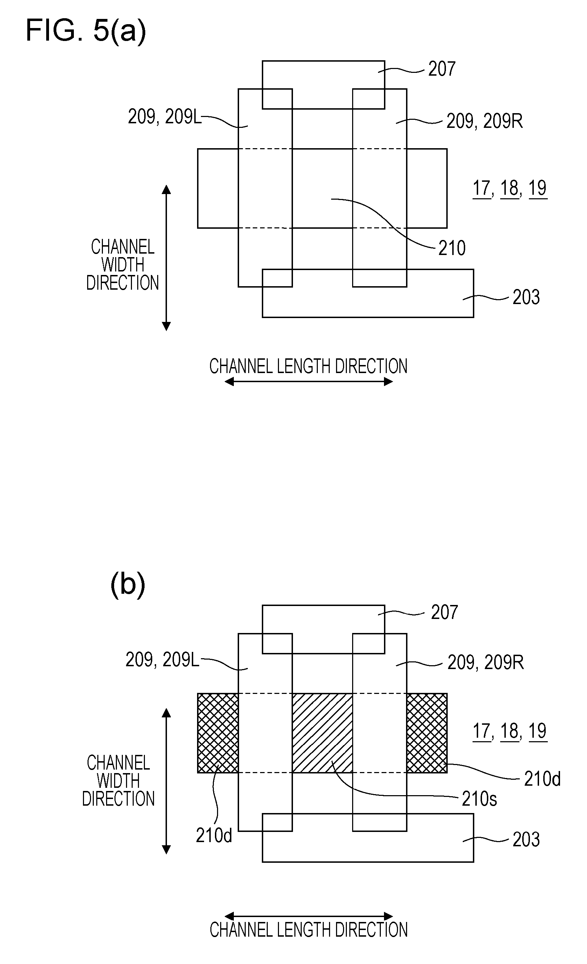

Next, planar structures of the first to third masks 17 to 19 and their mutual positional relationships will be explained. Figs. 5(a) and 5(b) are diagrams schematically illustrating the first to third masks 17 to 19 used in the steps illustrated in Fig. 4. The same parts as those in Fig. 4 are designated by the same reference numerals.

Figs. 5(a) and 5(b) each illustrate the first opening 209, the second opening 210, and the third openings 203 and 207. Fig. 5(b) illustrates each part of the second opening 210. In the present embodiment, the first opening 209, the second opening 210, and the third openings 203 and 207 are all rectangular in shape. The first mask 17 which defines the first opening 209 is outside the opening 209. The second mask 18 which defines the second opening 210 is outside the second opening 210. The third mask 19 which defines the third openings 203 and 207 is outside the third openings 203 and 207.

For ease of explanation, the first to third openings 209, 210, 203, and 207 overlap each other in Figs. 5(a) and 5(b). Thus, Figs. 5(a) and 5(b) illustrate alignment between the plurality of masks. In practice, the mask is removed after forming a predetermined semiconductor region in each step. This means that two or more masks are not necessarily present at the same time.

The first opening 209 and the second opening 210 intersect each other in plan view. In other words, an orthogonal projection of the first opening 209 onto a plane parallel to the surface of the semiconductor substrate 100 intersects an orthogonal projection of the second opening 210 onto the plane.

As illustrated in Fig. 5(b), the second opening 210 includes a source-side portion 210s corresponding to the source-side portion of the channel region 10, and a drain-side portion 210d corresponding to the drain-side portion of the channel region 10. In Fig. 5(b), a part of the second opening 210 between two first openings 209 is the source-side portion 210s of the second opening 210. Also in Fig. 5(b), a part to the left of a first opening 209L on the left side and a part to the right of a first opening 209R on the right side are each the drain-side portion 210d of the second opening 210.

In plan view, the source-side portion 210s and the drain-side portion 210d of the second opening 210 each overlap the first mask 17. In other words, an orthogonal projection of the source-side portion 210s onto a plane parallel to the surface of the semiconductor substrate 100 and an orthogonal projection of the drain-side portion 210d onto the plane each overlap an orthogonal projection of the first mask 17 onto the plane. Therefore, as illustrated in Fig. 5, the channel length of the JFET is defined by the ends of the first opening 209. The channel width of the JFET is defined by the ends of the second opening 210.

With this configuration, even though there could be alignment errors between the first mask 17 used to form the gate region 9 and the second mask 18 used to form the channel region 10, the shape of the channel of the JFET is almost unchanged. That is, variation in the channel length and the channel width of the JFET can be reduced. Thus, variation in the characteristics of the JFET can be reduced.

In the present embodiment, the first opening 209 includes a plurality of openings 209L and 209R separated by the first mask 17. Each of the openings 209L and 209R intersects the second opening 210 in plan view. In other words, each of orthogonal projections of the openings 209L and 209R onto a plane parallel to the surface of the semiconductor substrate 100 intersects the orthogonal projection of the second opening 210 onto the plane. In plan view, the source-side portion of the second opening 210 overlaps a part of the first mask 17 which is located between the two openings 209L and 209R.

In plan view, the first opening 209 partially overlaps the third openings 203 and 207. In other words, the orthogonal projection of the first opening 210 onto a plane parallel to the surface of the semiconductor substrate 100 partially overlaps the orthogonal projections of the third openings 203 and 207 onto the plane.

With this configuration, the effective channel width of the JFET can be widened. That is, since the driving force of the JFET can be improved, the imaging apparatus can be driven at a high speed.

In plan view, the entirety of the second opening 210 overlaps the third mask 19. With this configuration, when impurities are introduced into the semiconductor substrate 100 using the third mask 19, the amount of impurities introduced into the channel region 10 can be reduced. Therefore, even though the semiconductor region that electrically connects the gate regions 9 is formed, variation in the electrical characteristics of the JFET can be reduced.

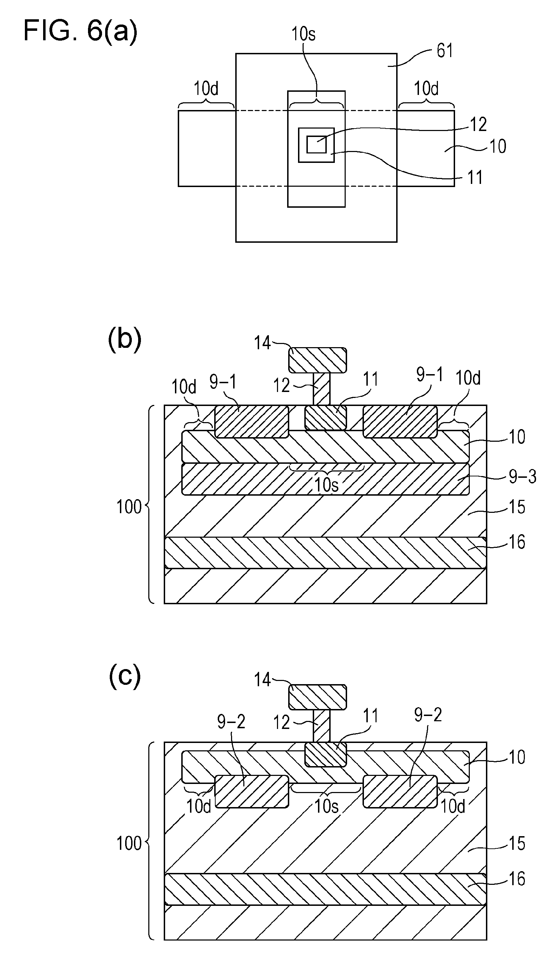

A modification of the present embodiment will be explained. Fig. 6(a) is a diagram schematically illustrating a planar structure of an imaging apparatus of the present embodiment. A JFET is illustrated in Fig. 6(a). The same parts as those in Fig. 1 are designated by the same reference numerals. The configuration of the present embodiment is the same as that of the first embodiment except for those described below.

The present embodiment is characterized by the shape of a gate region 61 of the JFET in plan view. Specifically, the gate region 61 surrounds the source-side portion of the channel region 10 in plan view. Two parts of the gate region 61 intersect the channel region 10 in plan view. The source-side portion and the drain-side portion of the channel region 10 do not overlap the gate region 61. Each of the source-side portion and the drain-side portion of the channel region 10 protrudes out of the gate region 61. Therefore, the channel length of the JFET is defined by the end of the gate region 61. The channel width of the JFET is defined by the end of the channel region 10.

With this configuration, even though there could be alignment errors between a mask used to form the gate region 61 and a mask used to form the channel region 10, the shape of the channel of the JFET is almost unchanged. That is, variation in the channel length and the channel width of the JFET can be reduced. Thus, variation in the characteristics of the JFET can be reduced.

In the modification illustrated in Fig. 6(a), the gate region 61 is a continuous planar region, and the surface gate region and the buried gate region are electrically continuous to each other in a portion which does not overlap the channel region 10. Thus, the effective channel width of the JFET can be widened while omitting the step of forming the semiconductor region having the same conductivity type and connecting the two gate regions. For example, the step of forming the FD region 3 in the embodiment illustrated in Fig. 1 can be omitted.

Another modification will be explained. Fig. 6(b) is a diagram schematically illustrating a cross-sectional structure of an imaging apparatus of the present embodiment. A JFET is illustrated in Fig. 6(b). The same parts as those in Fig. 1 are designated by the same reference numerals. The configuration of the present embodiment is the same as that of the first embodiment except for those described below.

In the JFET illustrated in Fig. 6(b), the gate region 9 includes the surface gate region 9-1 and the buried gate region 9-3. The buried gate region 9-3 is a P-type semiconductor region having a shape different from that of the surface gate region 9-1 in plan view. The buried gate region 9-3 is electrically connected to the surface gate region 9-1. In Fig. 6(b), the buried gate region 9-3 is identical to the channel region 10 in plan view. The buried gate region 9-3 may contain the channel region 10.

Another modification will be explained. Fig. 6(c) is a diagram schematically illustrating a cross-sectional structure of an imaging apparatus of the present embodiment. A JFET is illustrated in Fig. 6(c). The same parts as those in Fig. 1 are designated by the same reference numerals. The configuration of the present embodiment is the same as that of the first embodiment except for those described below. In the JFET illustrated in Fig. 6(c), the gate region 9 includes only the buried gate region 9-2.

In the modifications described above, the gate region 9 and the channel region 10 intersect each other. Therefore, variation in the electrical characteristics of the JFET can be reduced.

As described above, in some of the embodiments, variation in the characteristics of the JFET can be reduced.

### Second Embodiment

Another embodiment will be described. A difference from the first embodiment is that a structure for reducing a parasitic JFET current is provided under the source region of the JFET. The following description will focus only on the difference from the first embodiment, and the description of the same parts as those of the first embodiment will be omitted.

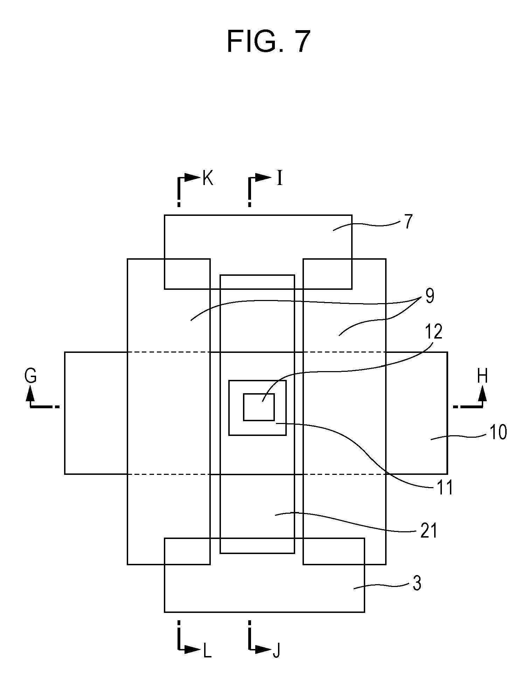

Fig. 7 is a diagram schematically illustrating a planar structure of an imaging apparatus of the present embodiment. A JFET is illustrated in Fig. 7. The other configuration of the pixel is not illustrated in Fig. 7. Parts having the same functions as those in the first embodiment are designated by the same reference numerals.

The pixel of the present embodiment includes a P-type semiconductor region 21. The P-type semiconductor region 21 overlaps the source region 11 in plan view. In other words, an orthogonal projection of the P-type semiconductor region 21 onto a plane parallel to the surface of the semiconductor substrate overlaps the source region 11 onto the plane. The P-type semiconductor region 21 is located between the two gate regions 9 in plan view. In other words, the orthogonal projection of the P-type semiconductor region 21 onto the plane parallel to the surface of the semiconductor substrate is located between the orthogonal projections of the two gate regions 9 onto the plane.

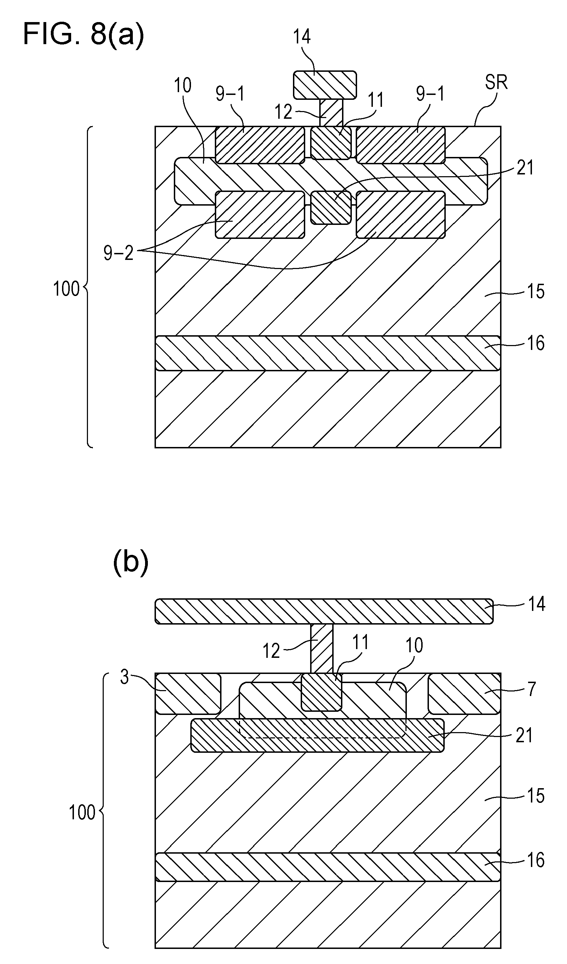

Fig. 8(a) is a diagram schematically illustrating a cross-sectional structure of the imaging apparatus of the present embodiment. Fig. 8(a) schematically illustrates the cross-sectional structure taken along line G-H in Fig. 7. The same parts as those in the first embodiment or Fig. 7 are designated by the same reference numerals.

As illustrated in Fig. 8(a), the P-type semiconductor region 21 is disposed at a position deeper than the channel region 10. When the P-type semiconductor region 21 and the channel region 10 are formed by ion implantation, a peak of an impurity density profile of the P-type semiconductor region 21 in the depth direction is located at a position deeper than a peek of an impurity density profile of the channel region 10 in the depth direction. The depth direction is a direction perpendicular to the surface SR.

In the present embodiment, the entirety of the P-type semiconductor region 21 is disposed at the same depth as the buried gate region 9-2. In Fig. 8(a), the P-type semiconductor region 21 and the buried gate region 9-2 are electrically connected to each other. The P-type semiconductor region 21 and the buried gate region 9-2 may be continuous to each other.

Fig. 8(b) is a diagram schematically illustrating a cross-sectional structure of the imaging apparatus of the present embodiment. Fig. 8(b) schematically illustrates the cross-sectional structure taken along line I-J in Fig. 7. The same parts as those in the first embodiment or Fig. 7 are designated by the same reference numerals.

As illustrated in Fig. 8(b), the P-type semiconductor region 21 is wider than the width of the channel region 10 in the channel width direction. In the present embodiment, the P-type semiconductor region 21 extends to reach a region below the source region 7 of the reset MOS transistor and a region below the FD region 3.

A cross-sectional structure taken along line K-L in Fig. 7 of the present embodiment is the same as that in the first embodiment. That is, Fig. 3(b) schematically illustrates the cross-sectional structure of the present embodiment.

With this configuration, electrical resistance between the channel region 10 and the N-type semiconductor region 15 can be increased. It is thus possible to reduce a parasitic current which runs through a region other than the channel defined by the gate region 9 and the channel region 10. Since the parasitic current is not highly dependent on the gate voltage, a large parasitic current degrades the current-voltage characteristics of the JFET. That is, reducing the parasitic current can improve the current-voltage characteristics of the JFET.

An impurity density in the P-type semiconductor region 21 is preferably lower than that in the buried gate region 9-2. With this relationship of impurity densities, even though there could be alignment errors between masks when forming the P-type semiconductor region 21, variation in the electrical characteristics of the JFET can be reduced.

A manufacturing method of the present embodiment can be obtained by adding the step of forming the P-type semiconductor region 21 to the manufacturing method of the first embodiment. The P-type semiconductor region 21 can be formed, for example, by using a mask such as that illustrated in Fig. 7.

As described above, the present embodiment can not only achieve the effect of the first embodiment, but can also reduce the parasitic JFET current.

### Third Embodiment

Another embodiment will be described. A difference from the first or second embodiment is that the JFET has an LDD structure. The following description will focus only on the difference from the first or second embodiment, and the description of the same parts as those of the first or second embodiment will be omitted.

A planar structure of an imaging apparatus of the present embodiment is the same as that of the first or second embodiment. That is, Fig. 1 or 7 schematically illustrates the planar structure of the imaging apparatus of the present embodiment. In the present embodiment, an N-type semiconductor region is added to regions indicated as the gate regions in Fig. 1 or 7.

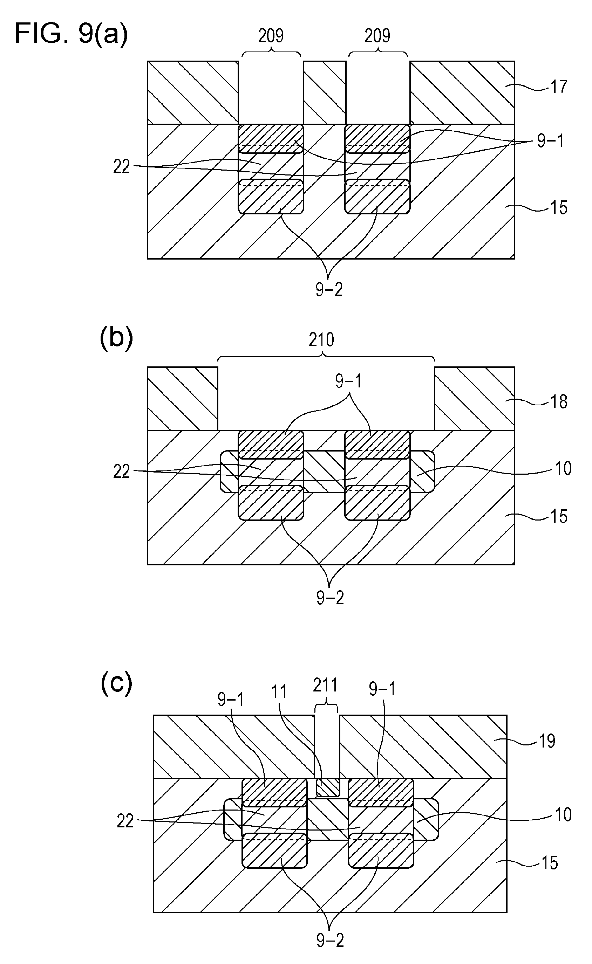

Fig. 9 is for explaining a method for manufacturing the imaging apparatus of the present embodiment. Each of Figs. 9(a) to 9(c) schematically illustrates a cross-sectional structure taken along line A-B in Fig. 1. That is, Figs. 9(a) to 9(c) each schematically illustrate a cross section including the channel length direction of the JFET. As in the second embodiment, the P-type semiconductor region 21 may be added to the structure illustrated in Fig. 9.

A step illustrated in Fig. 9(a) involves forming the surface gate region 9-1 and the buried gate region 9-2. A method for forming the surface gate region 9-1 and the buried gate region 9-2 is the same as that in the step illustrated in Fig. 4(a) of the first embodiment. As described in the first embodiment, this step involves using the first mask 17 which defines the first opening 209.

In the present embodiment, an N-type semiconductor region 22 is formed using the first mask 17 used to form the surface gate region 9-1 and the buried gate region 9-2. A donor, such as phosphorus or arsenic, is ion-implanted into the semiconductor substrate 100 through the first opening 209, whereby the N-type semiconductor region 22 is formed in a region corresponding to the first opening 209 of the semiconductor substrate 100.

As in the first embodiment, the first mask 17 is obtained, for example, by patterning a photoresist using a photolithography method. Alternatively, the first mask 17 may be a hard mask.

The N-type semiconductor region 22 overlaps the gate region 9 in plan view. In other words, an orthogonal projection of the N-type semiconductor region 22 onto a plane parallel to the surface of the semiconductor substrate 100 is identical to the orthogonal projection of the gate region 9 onto the plane. The N-type semiconductor region 22 is disposed at a depth between the surface gate region 9-1 and the buried gate region 9-2. When ion implantation is used to form the surface gate region 9-1, the buried gate region 9-2, and the N-type semiconductor region 22, the N-type semiconductor region 22 can be formed at the depth between the surface gate region 9-1 and the buried gate region 9-2 by controlling the ion implantation energy.

A step illustrated in Fig. 9(b) involves forming the channel region 10, as in the step illustrated in Fig. 4(b) of the first embodiment. Since the step of forming the channel region 10 is the same as that in the first embodiment, the detailed explanation will be omitted here.

A step illustrated in Fig. 9(c) involves forming the source region 11. Since the step of forming the source region 11 is the same as that in the first embodiment, the detailed explanation will be omitted here.

A part of the channel region 10 into which impurities have not been introduced in the step illustrated in Fig. 9(a) functions as an electric-field alleviation region. The channel is formed in a region where the channel region 10, which is an N-type semiconductor region, and the N-type semiconductor region 22 overlap each other. Impurities are introduced into this overlapping region during the two steps of forming the channel region 10 and forming the N-type semiconductor region 22. Therefore, the other part of the channel region 10, that is, the part into which impurities have not been introduced during the step of forming the N-type semiconductor region 22 has a relatively low impurity density. Thus, it is possible to lower an impurity density in a part of the channel region 10 which protrudes out of the gate region 9.

With the configuration where the drain region has a low impurity density, an electric field near the drain of the JFET can be alleviated. If a large electric field is generated near the drain of the JFET, the channel current causes impact-ionization near the drain, and thus generates carriers. The generated carriers may run into the gate of the JFET or the gate region 9 that accumulates signal carriers, whereby noise components of the pixel may be generated. The alleviation of the electrical field near the drain of the JFET can prevent the impact-ionization which causes such noise. As a result, noise in the pixel can be reduced.

Generally, the channel current of the JFET causes the impact-ionization in a pinch-off region near the drain region. To alleviate the electrical field in the pinch-off region and prevent the impact-ionization, it is preferable to lower the impurity density in the drain region.

In the present embodiment, the channel of the JFET may be formed only by the N-type semiconductor region 22, without forming the channel region 10. In this case, a part of the N-type semiconductor region 15 forms the drain region. Without the channel region 10, the channel width of the JFET is defined by a distance between the FD region 3 and the P-type source region 7 of the reset transistor in the channel width direction.

As described above, the present embodiment can achieve not only the effect of the first embodiment, but also noise reduction effect.

### Fourth Embodiment

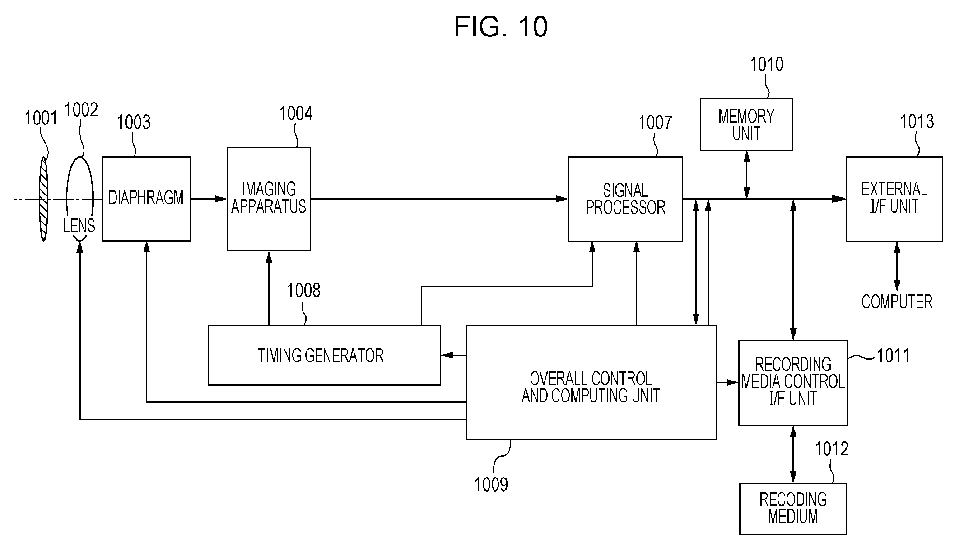

An embodiment of an imaging system according to the present invention will be described. Examples of the imaging system include digital still cameras, digital camcorders, copiers, facsimiles, mobile phones, in-vehicle cameras, and orbiting satellites. Camera modules including an optical system, such as a lens, and an imaging apparatus are also included in the examples of the imaging system. Fig. 10 is a block diagram of a digital still camera serving as an example of the imaging system.

In Fig. 10, reference numeral 1001 denotes a barrier for lens protection, reference numeral 1002 denotes a lens forming an optical image of a subject in an imaging apparatus 1004, and reference numeral 1003 denotes a diaphragm configured to change the amount of light passing through the lens 1002. Reference numeral 1004 denotes an imaging apparatus described in one of the embodiments and configured to convert the optical image formed by the lens 1002 as image data. An AD conversion unit is formed on a semiconductor substrate of the imaging apparatus 1004. Reference numeral 1007 denotes a signal processor configured to perform various corrections on imaged data output by the imaging apparatus 1004 or to compress the data. In Fig. 10, reference numeral 1008 denotes a timing generator configured to output various timing signals to the imaging apparatus 1004 and the signal processor 1007, and reference numeral 1009 denotes an overall control unit configured to control the entire digital still camera. Reference numeral 1010 denotes a frame memory unit for temporarily storing image data, reference numeral 1011 denotes an interface unit for recording onto or reading from a recording medium, and reference numeral 1012 denotes a removable recoding medium, such as a semiconductor memory, for recording or reading imaged data. Reference numeral 1013 denotes an interface unit for communicating with an external computer or the like. A timing signal or the like may be input from the outside of the imaging system. The imaging system needs to include at least the imaging apparatus 1004 and the signal processor 1007 configured to process an imaged signal output from the imaging apparatus 1004.

A configuration has been described in the present embodiment wherein the imaging apparatus 1004 and the AD conversion unit are formed on the same semiconductor substrate. Alternatively, the imaging apparatus 1004 and the AD conversion unit may be provided on different semiconductor substrates. The imaging apparatus 1004 and the signal processor 1007 may be formed on the same semiconductor substrate.

The imaging apparatus according to one of the first to third embodiments is employed as the imaging apparatus 1004 in the imaging system of the present embodiment.

The present invention is not restricted to the embodiments described above, and various changes and modifications are possible without departing from the spirit and scope of the present invention. The following claims are appended to disclose the scope of the present invention. Reference Signs List

100: semiconductor substrate
1: N-type semiconductor region (photoelectric conversion portion)
2: P-type semiconductor region (photoelectric conversion portion)
9: gate region
10: channel region
17: first mask
18: second mask
209: first opening
210: second opening

## Claims

1. A method for manufacturing an imaging apparatus that includes a plurality of pixels, each including a junction type field effect transistor provided in a semiconductor substrate, the method comprising:
a step of forming a gate region of the junction type field effect transistor by introducing an impurity into the semiconductor substrate using a first mask which defines a first opening; and
a step of forming a channel region of the junction type field effect transistor by introducing an impurity into the semiconductor substrate using a second mask which defines a second opening,
wherein the second opening includes a source-side portion corresponding to a source-side portion of the channel region, and a drain-side portion corresponding to a drain-side portion of the channel region;
an orthogonal projection of the first opening onto a plane parallel to a surface of the semiconductor substrate intersects an orthogonal projection of the second opening onto the plane; and
each of an orthogonal projection of the source-side portion of the second opening onto the plane and an orthogonal projection of the drain-side portion of the second opening onto the plane overlaps an orthogonal projection of the first mask onto the plane.

2. The method for manufacturing the imaging apparatus according to claim 1, wherein the gate region includes a surface gate region and a buried gate region formed at different depths;
the step of forming the gate region includes a plurality of ion implantation steps performed at different implantation energies and each using the first mask; and
the channel region is formed at a depth between the surface gate region and the buried gate region.

3. The method for manufacturing the imaging apparatus according to claim 2, wherein the implantation energies are selected such that the surface gate region and the buried gate region are formed at depths which allow electrical connection therebetween.

4. The method for manufacturing the imaging apparatus according to claim 2, further comprising a step of forming a first semiconductor region that electrically connects the surface gate region and the buried gate region.

5. The method for manufacturing the imaging apparatus according to any one of claims 1 to 4, wherein the first opening includes a plurality of openings separated by the first mask;
each of orthogonal projections of the plurality of openings onto the plane intersects the orthogonal projection of the second opening; and
the orthogonal projection of the source-side portion of the second opening overlaps an orthogonal projection of a part of the first mask onto the plane, the part being disposed between the plurality of openings.

6. The method for manufacturing the imaging apparatus according to claim 5, wherein the step of forming the gate region includes a step of forming a plurality of gate regions corresponding to the plurality of openings,
the method further comprising a step of forming a second semiconductor region that electrically connects the plurality of gate regions to each other.

7. The method for manufacturing the imaging apparatus according to claim 6, wherein the step of forming the second semiconductor region is performed using a third mask which defines a third opening;
the orthogonal projection of the first opening partially overlaps an orthogonal projection of the third opening onto the plane; and
entirety of the orthogonal projection of the second opening overlaps an orthogonal projection of the third mask onto the plane.

8. The method for manufacturing the imaging apparatus according to any one of claims 1 to 7, further comprising a step of forming a source region electrically connected to the source-side portion of the channel region.

9. The method for manufacturing the imaging apparatus according to any one of claims 1 to 8, wherein a channel length and a channel width of the junction type field effect transistor are defined by a portion where the orthogonal projection of the first opening onto the plane parallel to the surface of the semiconductor substrate overlaps the orthogonal projection of the second opening onto the plane.

10. The method for manufacturing the imaging apparatus according to any one of claims 1 to 9, wherein a periphery of the orthogonal projection of the first opening includes two lines parallel to each other; and
a periphery of the orthogonal projection of the second opening includes two lines parallel to each other.

11. A method for forming an imaging apparatus that includes a plurality of pixels, each including a junction type field effect transistor provided in a semiconductor substrate, the method comprising:
a step of forming a gate region of the junction type field effect transistor in the semiconductor substrate; and
a step of forming a channel region of the junction type field effect transistor in the semiconductor substrate,
wherein an orthogonal projection of a first region onto a plane parallel to a surface of the semiconductor substrate intersects an orthogonal projection of a second region onto the plane, the first region being a region into which an impurity is introduced in the step of forming the gate region, the second region being a region into which an impurity is introduced in the step of forming the channel region; and
in the plane, each of a source-side portion and a drain-side portion of the orthogonal projection of the second region protrudes out of the orthogonal projection of the first region.

12. An imaging apparatus comprising a plurality of pixels, each including a junction type field effect transistor provided in a semiconductor substrate,
wherein the junction type field effect transistor includes a gate region and a channel region;
an orthogonal projection of the gate region onto a plane parallel to a surface of the semiconductor substrate intersects an orthogonal projection of the channel region onto the plane; and
in the plane, each of a source-side portion and a drain-side portion of the orthogonal projection of the channel region protrudes out of the orthogonal projection of the gate region.

13. The imaging apparatus according to claim 12, wherein the gate region includes a surface gate region and a buried gate region disposed at different depths;
the channel region is disposed at a depth between the surface gate region and the buried gate region; and
an orthogonal projection of the surface gate region onto the plane is identical to an orthogonal projection of the buried gate region onto the plane.

14. The imaging apparatus according to claim 12 or 13, wherein the gate region includes a plurality of regions which are electrically connected to each other and arranged, with a source region of the junction type field effect transistor interposed therebetween; and
each of orthogonal projections of the plurality of regions onto the plane intersects the orthogonal projection of the channel region.

15. The imaging apparatus according to any one of claims 12 to 14, wherein a periphery of the orthogonal projection of the gate region includes two lines parallel to each other; and
a periphery of the orthogonal projection of the channel region includes two lines parallel to each other.

16. An imaging apparatus comprising a plurality of pixels, each including a junction type field effect transistor provided in a semiconductor substrate,
wherein the junction type field effect transistor includes a surface gate region, a buried gate region, and a channel region which are disposed at different depths;
the channel region is disposed at a depth between the surface gate region and the buried gate region; and
each of an orthogonal projection of the surface gate region onto a plane parallel to a surface of the semiconductor substrate and an orthogonal projection of the buried gate region onto the plane intersects an orthogonal projection of the channel region onto the plane.

17. The imaging apparatus according to claim 16, wherein the surface gate region includes a plurality of regions which are electrically connected to each other and arranged, with a source region of the junction type field effect transistor interposed therebetween; and
each of orthogonal projections of the plurality of regions onto the plane intersects the orthogonal projection of the channel region.

18. The imaging apparatus according to claim 16, wherein the buried gate region includes a plurality of regions which are electrically connected to each other and arranged, with a source region of the junction type field effect transistor interposed therebetween; and
each of orthogonal projections of the plurality of regions onto the plane intersects the orthogonal projection of the channel region.

19. An imaging system comprising:
the imaging apparatus according to any one of claims 12 to 18; and
a lens configured to form an optical image of a subject in the imaging apparatus.

20. An imaging system comprising:
the imaging apparatus according to any one of claims 12 to 18; and
a signal processor configured to process a signal output from the imaging apparatus.
